# EUROPEAN PATENT APPLICATION

(11) **EP 2 679 779 A2**
(43) Date of publication of application: **01.01.2014**
(21) Application number: 13173050.9
(22) Date of filing: 20.06.2013
(51) Int. Cl.: F01D 25/00, F02C 7/30, C23C 14/48

(54) **Modified rotor component and method for modifing a wear charcteristic of a rotor component in a turbine system**

(30) Priority: 27.06.2012 US 201213534503
(71) Applicant: General Electric Company, Schenectady, New York 12345 (US)
(72) Inventor: Bucci, David Vincent, Greenville, SC South Carolina 29615 (US); Pope, Stephen Gerard, Greenville, SC South Carolina 29615 (US); Parolini, Jason Robert, Greenville, SC South Carolina 29615 (US)
(74) Representative: Szary, Anne Catherine

(57) **Abstract**

A method for modifying a wear characteristic of a rotor component in a turbine system and a modified rotor component for a turbine system are disclosed. The method includes implanting ions of one of a Group 6 element, a Group 13 element, or a metalloid element through an exterior surface of a rotor component. The rotor component is one of a rotor wheel or a distance wheel.

## Description

### FIELD OF THE INVENTION

The present disclosure relates in general to rotor components for use in turbine systems, and more particularly to methods for modifying wear characteristics of the rotor components and modified rotor components.

### BACKGROUND OF THE INVENTION

Turbine systems are widely utilized in fields such as power generation. For example, a conventional gas turbine includes a compressor section, a combustor section, and at least one turbine section. The compressor section is configured to compress air as the air flows through the compressor section. The air is then flowed from the compressor section to the combustor section, where it is mixed with fuel and combusted, generating a hot gas flow. The hot gas flow is provided to the turbine section, which utilizes the hot gas flow by extracting energy from it to power the compressor, an electrical generator, and other various loads.

During operation of a turbine system, the various components of the turbine system endure various forms of wearing. Such wearing can lead to damage and/or failure of the individual components and the turbine system in general. Rotor components, which rotate during operation of the turbine system, are particularly susceptible to wearing. For example, present rotor components may be expected to operate for approximately 150,000 hours and 5,000 starts. Further, in many cases, specific wear sensitive locations on the components, such as on the rotor components, may tend to wear faster than other locations. These wear sensitive locations may limit the lives of the associated rotor components.

Various techniques are known in the art for attempting to modify the wear characteristics of turbine system components, and in particular of rotor components. For example, powder pack deposition techniques have been utilized to coat exterior surfaces of rotor components. However, such techniques are difficult to perform during in-field service repairs, and cause component distortion issues. A particular concern of many techniques is that the exterior surface of the rotor component is altered. This can lead to performance issues due to the tight tolerances to which the turbine system components are manufactured. Further, the exterior coatings can be relatively brittle, and can be expensive to replace and/or repair.

Thus, improved rotor components are desired in the art. In particular, rotor components having improved wear characteristics while maintaining operational tolerances would be desired. For example, improved methods for modifying wear characteristics of rotor components, and improved modified rotor components, would be advantageous.

### BRIEF DESCRIPTION OF THE INVENTION

Aspects and advantages of the invention will be set forth in part in the following description, or may be obvious from the description, or may be learned through practice of the invention.

In one embodiment, a method for modifying a wear characteristic of a rotor component in a turbine system is disclosed. The method includes implanting ions of one of a Group 6 element, a Group 13 element, or a metalloid element through an exterior surface of a rotor component. The rotor component is one of a rotor wheel or a distance wheel.

In another embodiment, a modified rotor component for a turbine system is disclosed. The modified rotor component includes a rotor component. The rotor component includes a body and an exterior surface. The body includes a base layer and an implantation layer. The implantation layer is disposed between the base layer and the exterior surface. The implantation layer includes a base metal and a plurality of ions implanted into the base metal through the exterior surface. The ions are of one of a Group 6 element, a Group 13 element, or a metalloid element. The rotor component is one of a rotor wheel or a distance wheel.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

### BRIEF DESCRIPTION OF THE DRAWINGS

A full and enabling disclosure of the present invention, including the best mode thereof, directed to one of ordinary skill in the art, is set forth in the specification, which makes reference to the appended figures, in which:
FIG. 1 is a partial cross-sectional view of a gas turbine according to one embodiment of the present disclosure;
FIG. 2 is a partial perspective view of a rotor wheel according to one embodiment of the present disclosure;
FIG. 3 is a close-up perspective view of a dovetail channel of a rotor wheel according to one embodiment of the present disclosure;
FIG. 4 is a perspective view of a distance wheel according to one embodiment of the present disclosure;
FIG. 5 is a cross-sectional view of a modified rotor component according to one embodiment of the present disclosure; and
FIG. 6 is a schematic diagram of an ion deposition apparatus according to one embodiment of the present disclosure.

### DETAILED DESCRIPTION OF THE INVENTION

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment can be used with another embodiment to yield a still further embodiment. Thus, it is intended that the present invention covers such modifications and variations as come within the scope of the appended claims and their equivalents.

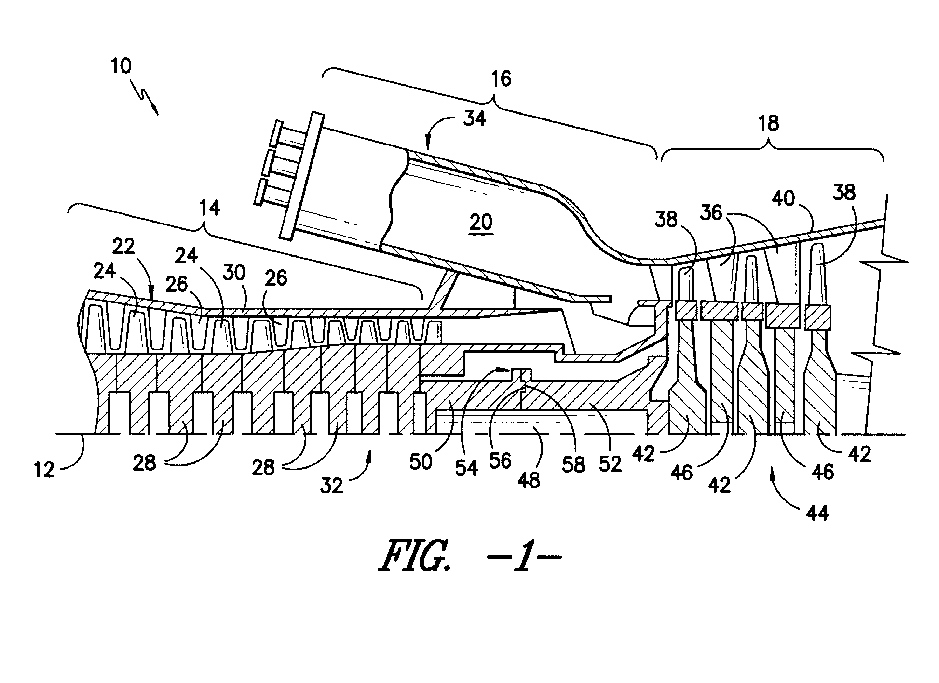

Referring now to the drawings, FIG. 1 illustrates a partial, cross-sectional view of one embodiment of a turbine system 10. In this embodiment, the turbine system is a gas turbine. It should be understood that the turbine system 10 of the present disclosure need not be a gas turbine system, but rather may be any suitable turbine system 10, such as a steam turbine system or other suitable system. The turbine system 10 as shown is cut-off at the turbine's centerline 12. As shown, the turbine system 10 includes a compressor section 14, a combustion section 16 disposed downstream of the compressor section 14 and a turbine section 18 disposed downstream of the combustion section 16. The compressor section 14 may generally be configured to pressurize air flowing into the turbine system 10. A portion of the pressurized air or working fluid then flows into the combustion section 16, wherein the air is mixed with fuel and combusted. Hot gases of combustion then flow through a transition piece 20 along an annular hot gas path to the turbine section 18 to drive the gas turbine 10 and generate power.

In several embodiments, the compressor section 14 may include an axial flow compressor 22 having a plurality of compressor stages characterized by alternating rows of rotor blades 24 and stator vanes 26. Specifically, each compressor stage may include a row of circumferentially spaced rotor blades 24 mounted to a compressor rotor wheel 28 and a row of circumferentially spaced stator vanes 26 attached to a static compressor casing 30. The alternating rows of rotor blades 24 and stator vanes 26 may generally be configured to incrementally increase the pressure of the air flowing through the compressor 22 such that a desired increase in pressure is reached. The compressor rotor wheels 28, along with the rotor blades 24, generally comprise the rotating components of the compressor 22 and, thus, may form a compressor rotor assembly 32. For example, in several embodiments, the compressor rotor disks 28 may be stacked axially against one another about the turbine centerline 12 such that torque may be transmitted between the rotor disks 28.

The combustion section 16 of the gas turbine 10 may generally be characterized by a plurality of combustors 34 (one of which is shown) disposed in an annular array about the turbine centerline 12. Each combustor 34 may generally be configured to receive a portion of the pressurized air discharged from the compressor 22, mix the air with fuel to form an air/fuel mixture and combust the mixture to produce hot gases of combustion. As indicated above, the hot gases of combustion may then flow from each combustor 34 through a transition piece 20 to the turbine section 18 of the gas turbine 10.

The turbine section 18 may generally include a plurality of turbine stages characterized by alternating rows of turbine nozzles 36 and turbine buckets 38. In particular, each turbine stage may include a row of circumferentially spaced turbine nozzles 36 attached to a static turbine casing 40 and a row of circumferentially spaced turbine buckets 38 mounted to a turbine rotor wheel 42. The alternating rows of turbine nozzles 36 and buckets 38 may generally be configured to incrementally convert the energy of the hot gases of combustion into work manifested by rotation of the turbine rotor disks 42. The turbine rotor wheels 42, along with the turbine buckets 38, may generally comprise the rotating components of the turbine section 18 and, thus, may form a turbine rotor assembly 44. Similar to the compressor rotor wheels 28, the turbine rotor wheels 42 may generally be stacked together axially along the turbine centerline 12. For example, as shown in FIG. 1, the turbine rotor wheels 42 may be spaced apart from one another by spacer wheels 46, with the rotor wheels 42 and spacer wheels 46 being stacked axially against one another such that torque may be transmitted between the rotor disks 42. Spacer wheels may additionally or alternatively space art the compressor rotor wheels 28.

As further shown in FIG. 1, the compressor rotor assembly 32 may further include a compressor distance wheel 50, and the turbine rotor assembly 44 may further include a turbine distance wheel 52. The distance wheels 50, 52 may couple the compressor rotor assembly 32 and the turbine rotor assembly 44 together. For example, each distance wheel 50, 52 may include a mating flange. The flanges may form a marriage joint 54, which couples the compressor rotor assembly 32 and the turbine rotor assembly 44 together. The mating flanges in exemplary embodiments are rabbet flanges, as shown. For example, one of the distance wheels 50, 52 may include a male rabbet flange 56, while the other of the distance wheels 50, 52 may include a mating female rabbet flange 58. It should be understood, however, that the marriage joint is not limited to marriage joints having rabbet flanges, and rather that any suitable marriage joint having any suitable flanges or other coupling features is within the scope and spirit of the present disclosure.

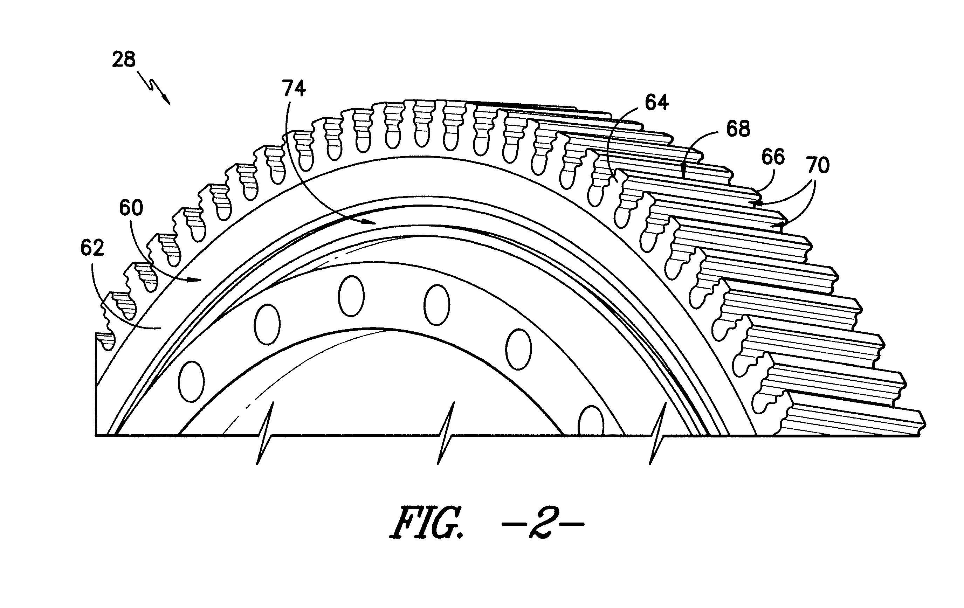

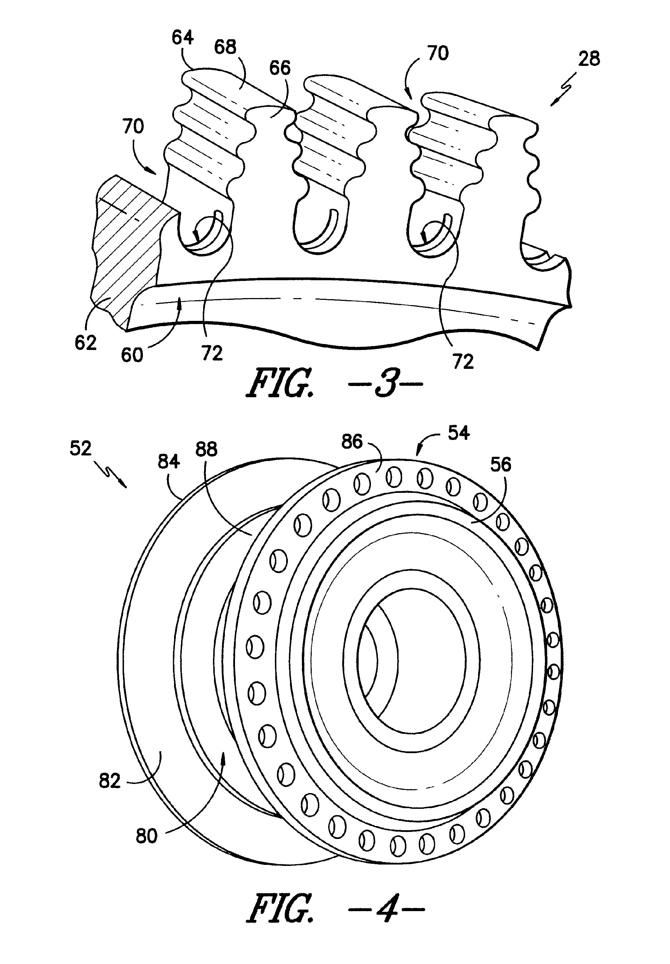

FIGS. 2 and 3 illustrate a rotor wheel according to various embodiments of the present disclosure. The rotor wheel as shown is a compressor rotor wheel 28, but in other embodiments could be a turbine rotor wheel 42. The rotor wheel 28 as shown includes a body 60 and an exterior surface 62. The body 60 is in exemplary embodiments a generally cylindrical body, as shown, and thus includes a first side 64, a second side 66, and an outer peripheral edge 68 extending between the first side 64 and the second side 66. The outer peripheral edge 68 may include a plurality of channels 70 disposed in a generally annular array. Each channel may generally extend between the first side 64 and the second side 66, such as from the first side 64 to the second side 66. The channels 70 are sized and shaped to accommodate protrusions of the associated blades 24 or buckets 38, to couple the blades 24 or buckets 28 to the wheel. In exemplary embodiments, the channels 70 are dovetail channels that are sized and shaped to accommodate dovetail protrusions of the associated blades 24 or buckets 38. One or more cooling slots 72 may be defined in the exterior surface 62 in one or more of the channels 70. The channels 70 may be disposed adjacent to the first side 64 or the second side 66 of a channel 70, or at any other suitable location within the channel 70. Cooling medium may be supplied through the cooling slot 72 into the associated blade 24 or bucket 28.

The first side 64 and/or the second side 66 may include a balance rail 74. The balance rail 74 may be a generally circumferential protrusion extending from the first side 64 and/or second side 66. The balance rail 74 may interact with adjacent wheels, such as rotor wheels or spacer wheels, to balance the rotor wheel and rotor assembly.

FIG. 4 illustrates a distance wheel according to one embodiment of the present disclosure. The distance wheel as shown is a turbine distance wheel 52, but in other embodiments could be a compressor distance wheel 50. The distance wheel 52 as shown includes a body 80 and an exterior surface 82. The body 80 is in exemplary embodiments a generally cylindrical body, as shown, and thus includes a first side 84, a second side 86, and an outer peripheral edge 88 extending between the first side 84 and the second side 86. As discussed, the first side 84 8or the second side 86 may include a flange, which in exemplary embodiments may be a male rabbet flange 56 as shown or a female rabbet flange 58. The flange may be a generally circumferential protrusion (if male) or depression (if female) extending from defined in the first side 64 and/or second side 66. A marriage joint 54 may be formed between the distance wheels 50, 52 by the mating flanges when coupled together.

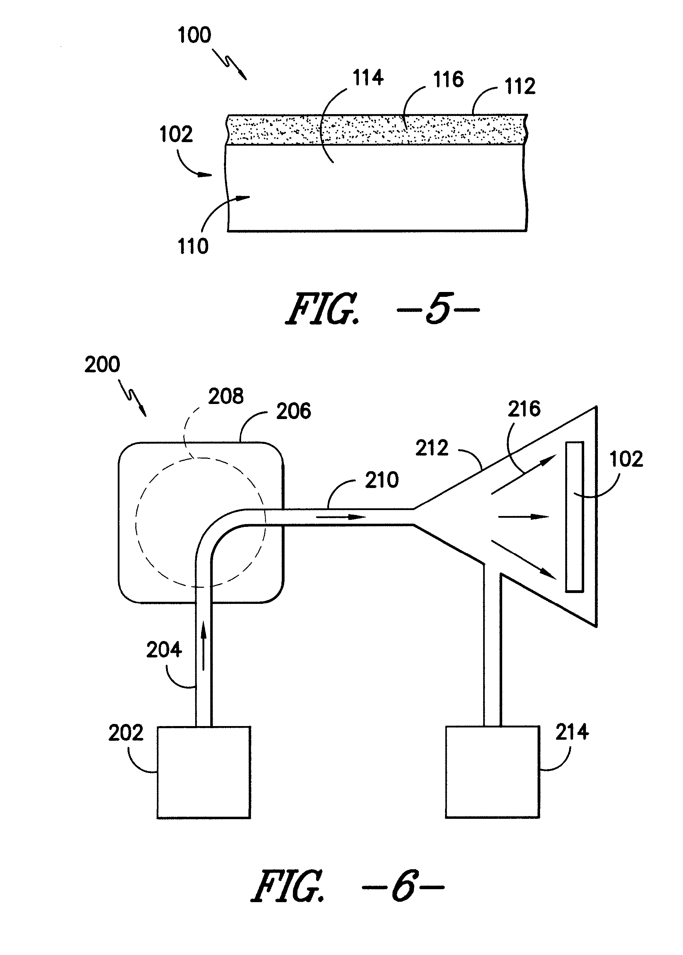

The present disclosure is further directed to modified rotor components for turbine systems 10. A cross-sectional view of a modified rotor component 100 is illustrated in FIG. 5. The modified rotor component 100 includes a rotor component 102. The rotor component 102 may be, for example, a rotor wheel, such as a compressor rotor wheel 28 or turbine rotor wheel 42; a spacer wheel, such as a compressor spacer wheel or turbine spacer wheel 46; or a distance wheel, such as a compressor distance wheel 50 or turbine spacer wheel 52. The rotor component 102 includes a body 110 and an exterior surface 112, as shown and discussed above with regard to rotor wheels and distance wheels.

Modified rotor components 100 according to the present disclosure are modified using ion implantation. During implantation, ions of specific elements may be implanted into the rotor component 102. The ions are implanted through the exterior surface 112 into the body 110 of the rotor component 102. As shown in FIG. 5, the body 110 may thus comprise a base layer 114 and an implantation layer 116. The base layer 114 includes the base material that the rotor component 102 is formed from. In exemplary embodiments, for example, the base material is a base metal. The base metal may be, for example, a suitable aluminum-based, iron-based, nickel-based, austenitic nickel chromium based, or chromium molybdenum vanadium based alloy or superalloy, or any other suitable metal, alloy, or superalloy. In other embodiments, any suitable material may be utilized as a base material. The base layer 114 generally does not include any ions implanted in the base material. The implantation layer 116, on the other hand, includes the base material as well as a plurality of ions implanted into the base material. The implantation layer 116 is disposed between the base layer 114 and the exterior surface 112. Ions are thus implanted through the exterior surface 112 into the implantation layer 116.

The implantation of ions into the body 110 of a rotor component 102 according to the present disclosure may provide various wear characteristic modifications for the resulting modified rotor component 100. For example, wear mechanisms that are of increased concern for rotor components 102 include, for example, fretting wear and dwell or hold time fatigue ("fatigue"). Fretting wear is repeated rubbing, which may be cyclical in nature, between two surfaces. Over a period of time, fretting wear will remove material from one or both surfaces in contact. Fatigue is a process by which the surface of a material is weakened, such as by cyclic loading. Surface cracking may occur due to the detachment of wear particles from each other. Ions suitable for implantation into rotor components 102 according to the present disclosure may modify the various wear characteristics of the rotor components 102, which are the characteristics of the rotor component 102 or modified rotor component 100 in responding to the various wear mechanisms. For example, the implantation of ions may improve the resistance of the modified rotor component 100 to fretting wear, fatigue, or other suitable wear mechanisms that may occur during operation of the turbine system 10.

Ions suitable for implantation into a rotor component 102 according to the present disclosure include Group 6 elements, Group 13 elements, or metalloid elements. Group 6 elements include chromium, molybdenum, tungsten, and seaborgium. Group 13 elements include boron, aluminum, gallium, indium, thallium, and ununtrium. Metalloid elements include boron, silicon, germanium, arsenic, antimony, tellurium, and polonium. In some exemplary embodiments, for example, boron ions may be implanted into a rotor component 102 to form a modified rotor component 100. The implantation of boron may improve resistance of the modified rotor component 100 to fatigue during operation of the turbine system 10. In other exemplary embodiments, for example, molybdenum ions may be implanted into a rotor component 102 to form a modified rotor component 100. The implantation of molybdenum may improve resistance of the modified rotor component 100 to fretting wear during operation of the turbine system 10.

FIG. 6 illustrates one embodiment of an ion implantation apparatus 200 according to the present disclosure. Ions may be implanted into a rotor component 100 in a suitable ion implantation apparatus such as the apparatus 200 as shown in FIG. 6 to form a modified rotor component 100. In general, ion implantation is a process by which ions of a material, such as of an element as discussed above, are accelerated in an electrical field and impacted into a solid material, such as into the exterior surface 112 of a rotor component 102. The ions may be implanted through the exterior surface 112 into the body 110 of the rotor component 102, thus forming an implantation layer 116 of a modified rotor component 100.

Ion implantation apparatus 200 may include, for example, a source chamber 202. Ions of a material are produced in the source chamber 202 by, for example, stripping electrons from a source material in a plasma. The ions are then accelerated in a first acceleration chamber 204, and enter a mass analysis chamber 206. An analyzer magnet 208 may be disposed in the mass analysis chamber 206. Ions suitable for implantation are selected in the mass analysis chamber 206 based on, for example, charge-to-mass ratio, species, isotope, charge state, or another suitable characteristic. The ions are then accelerated in a second acceleration chamber 210. Finally, the ions may enter an implantation chamber 212. The solid material in which the ions are being implanted, such as the rotor component 102, may be disposed in the chamber. A pump 214 may evacuate the chamber 212 to create a vacuum environment. Beam 216 of ions entering the chamber 212 may be scanned over the rotor component 102, or portions thereof, to implant ions therein.

In some embodiments, ion implantation may occur over the entire exterior surface 112 of the rotor component 102 to form the modified rotor component 100. In other embodiments, however, the implanted ions may be selectively applied to wear sensitive locations on the rotor component 102. A wear sensitive location is a location that tends to wear faster than surrounding locations, and may thus be a life-limiting location of the rotor component. Examples of life-limiting locations include, for example, channels 70, such as dovetail channels 70, and in exemplary embodiments the portions of a channel 70 adjacent to a cooling slot 72 defined therein; balance rails 74, marriage joints 54 and components thereof, such as flanges, such as male rabbet flanges 56 and female rabbet flanges 58. The implanted ions may thus be selectively applied to one or more wear sensitive locations on a rotor component 102 to modify wear characteristics at these locations. This selective implantation may in exemplary embodiments occur without any implantation of other locations on the rotor component 100. Thus, the ions may be selectively disposed in the modified rotor component 100 only at the wear sensitive locations. Such selective implantation may be facilitated by, for example, shielding portions of the rotor component 102 other than the wear sensitive locations during the ion implantation process. The shield material may, for example, absorb the ions to prevent them from being implanted into the rotor component 100 except at the desired wear sensitive locations.

As discussed above, ions are implanted through an exterior surface 112 of a rotor component 102 to form a modified rotor component 100. In some embodiments, the ions are implanted to a depth of up to approximately 0.1 microns, such as to a depth of between approximately 0.01 microns and approximately 0.1 microns. The depth may be measured from the exterior surface 112, and may define the thickness of the implantation layer 116 of the body 110. Further, implantation of the ions into the rotor component 102 to form the modified rotor component 100 may in some of these embodiments desirably be performed at a temperature in a range between approximately 0° F and approximately 150° F. Optional heat treating of the modified rotor component 100 after implantation may further allow the ions to diffuse within the rotor component 102. It should be understood, however, that such implantation may be performed at any suitable temperature.

In other embodiments, the ions are implanted to a depth of up to approximately 1 micron, such as to a depth of between approximately 0.01 microns and approximately 1 micron. The depth may be measured from the exterior surface 112, and may define the thickness of the implantation layer 116 of the body 110. Further, implantation of the ions into the rotor component 102 to form the modified rotor component 100 may in some of these embodiments desirably be performed at a temperature in a range between approximately 500° F and approximately 1000° F, such as between approximately 800° F and approximately 1000° F. In these embodiments, the relatively higher temperature levels may allow the ions to diffuse within the rotor component 102 during implantation. It should be understood, however, that such implantation may be performed at any suitable temperature.

The present disclosure is further directed to methods for modifying a wear characteristic of a rotor component 102. A method includes, for example, implanting ions through an exterior surface 112 of a rotor component 102. The ions may, for example, be implanted using ion implantation apparatus 200 as discussed above. The ions are of a Group 6 element, a Group 13 element, or a metalloid element. The rotor component 102 may be, for example, a rotor wheel, such as a compressor rotor wheel 28 or turbine rotor wheel 42; a spacer wheel, such as a compressor spacer wheel or turbine spacer wheel 46; or a distance wheel, such as a compressor distance wheel 50 or turbine spacer wheel 52.

The implantation of ions as discussed herein may provide a variety of advantages for rotor components 102. For example, as discussed, fretting wear and/or fatigue may be reduced, which may thus increase the life expectancy of the rotor components 102. Further, the use of ion implantation as discussed eliminates the need to heat treat or otherwise alter a rotor component 102, which may cause the dimensions of the rotor component 102 to be altered out of the appropriate engineering tolerances. Still further, the use of ion implantation eliminates the need to post process the rotor components after implantation. Additionally, the risk of detrimental chemical reactions which could be detrimental to the various properties of the rotor component 102, are eliminated. Further, in some embodiments, utilized of ion implantation according to the present disclosure may allow for the creation of a high temperature low cycle fatigue layer on the modified rotor component 100, such as on a peened surface thereof, without any significant stress relation in the outer layer, such as the peened layer, of the modified rotor component 100. This would add an additional layer of protection against high temperature low cycle fatigue crack initiation, and the peened layer would provide this protection at increased depths. Further, creation of such a layer would not be possible when using other previously known techniques, such as powder pack techniques with associated high temperature diffusion heat treatments.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A method for modifying a wear characteristic of a rotor component in a turbine system, the method comprising:
implanting ions of one of a Group 6 element, a Group 13 element, or a metalloid element through an exterior surface of a rotor component,
wherein the rotor component is one of a rotor wheel or a distance wheel.

2. The method of claim 1, wherein the implanting step comprises implanting ions of boron or molybdenum.

3. The method of claim 1 or claim 2, wherein the implanted ions are selectively applied to a wear sensitive location on the rotor component.

4. The method of claim 3, wherein the rotor component is a rotor wheel and the wear sensitive location is one of a dovetail channel or a balance rail or the rotor component is a distance wheel and the wear sensitive location is a rabbet flange.

5. The method of any preceding claim, wherein the ions are implanted to a depth of up to approximately 1 micron.

6. The method of any preceding claim, wherein the ions are implanted to a depth of up to approximately 0.1 microns.

7. The method of any preceding claim, wherein the ions are implanted at a temperature in a range between approximately 0° F and approximately 150° F.

8. The method of any one of claims 1 to 6, wherein the ions are implanted at a temperature in a range between approximately 500° F and approximately 1000° F.

9. The method of claim 1, wherein the rotor component is a compressor section rotor component.

10. A modified rotor component for a turbine system, the modified rotor component comprising:
a rotor component, the rotor component comprising a body and an exterior surface,
the body comprising a base layer and an implantation layer, the implantation layer disposed between the base layer and the exterior surface, the implantation layer comprising a base metal and a plurality of ions implanted into the base metal through the exterior surface,
wherein the ions are of one of a Group 6 element, a Group 13 element, or a metalloid element, and
wherein the rotor component is one of a rotor wheel or a distance wheel.

11. The modified rotor component of claim 10, wherein the ions are boron or molybdenum.

12. The modified rotor component of claim 10 or claim 11, wherein the ions are selectively disposed in a wear sensitive location on the rotor component.

13. The modified rotor component of any one of claims 10 to 12, wherein the rotor component is a rotor wheel and the wear sensitive location is one of a dovetail channel or a balance rail or wherein the rotor component is a distance wheel and the wear sensitive location is a rabbet flange.

14. The modified rotor component of any of claims 10 to 13, wherein the ions are implanted to a depth of up to approximately 0.1 microns or wherein the ions are implanted to a depth of up to approximately 1 micron.

15. The modified rotor component of any one of claims 10 to 14, wherein the rotor component is a compressor section rotor component.
